(19) Europäisches Patentamt

**European Patent Office**

**Office européen des brevets**

(11) Veröffentlichungsnummer: **0 289 794 B1**

(12) **EUROPÄISCHE PATENTSCHRIFT**

(45) Veröffentlichungstag der Patentschrift: **16.12.92**

(51) Int. Cl.⁵: **H01L 27/01**

(21) Anmeldenummer: **88105514.9**

(22) Anmeldetag: **07.04.88**

(54) **RC-Leitung.**

(30) Priorität: **02.05.87 DE 3714672**

(43) Veröffentlichungstag der Anmeldung:
**09.11.88 Patentblatt 88/45**

(45) Bekanntmachung des Hinweises auf die
Patenterteilung:
**16.12.92 Patentblatt 92/51**

(84) Benannte Vertragsstaaten:
**CH FR GB IT LI NL**

(56) Entgegenhaltungen:
**EP-A- 0 013 173**
**GB-A- 2 040 591**
**US-A- 3 665 346**

**VDI-ZEITSCHRIFTEN, Reihe 9, 1984, Seiten
110-119: "Analoge Zeitkontinuierliche Filter
in NMOS-Technologie"**

(73) Patentinhaber: **TELEFUNKEN electronic GmbH
Theresienstrasse 2
W-7100 Heilbronn(DE)**

(72) Erfinder: **Tomaszewski, Zbigniew, Dr.
Schöttlestrasse 26b
W-7100 Heilbronn(DE)**
Erfinder: **Tröster, Gerhard, Dr.
Ludwig-Pfau-Strasse 31
W-7100 Heilbronn(DE)**

(74) Vertreter: **Maute, Hans-Jürgen, Dipl.-Ing.
TELEFUNKEN electronic GmbH Theresienstrasse 2
W-7100 Heilbronn(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine RC-Leitung als Dreischichtstruktur auf einem Halbleitergrundkörper, bestehend aus zwei leitenden Polysilizium-Schichten, wobei zwischen diesen beiden Schichten eine Oxidschicht angeordnet ist und eine der Polysilizium-Schichten den ohmschen Widerstand und zugleich den ersten Kapazitätsbelag bildet und die andere Polysilizium-Schicht den zweiten Kapazitätsbelag realisiert, wobei die Oxidschicht das Dielektrikum darstellt.

RC-Leitungen sind für unterschiedliche Anwendungen bekannt und werden mit den standardisierten Technologien, wie MOS-, NMOS- und CMOS-Technologie oder eine aus Bipolar- und CMOS-Technologie kombinierte Technologie, hergestellt. RC-Leitungen werden als Bauelemente für die Filtersynthese eingesetzt, wobei Widerstände und Kondensatoren nicht als diskrete Bauelemente nebeneinander, sondern übereinander angeordnet werden, wodurch ein RC-verteiltes Element aufgebaut wird. Weiterhin werden RC-Leitungen als Verzögerungsleitung in Filtern und Generatoren verwendet. Zeitkontinuierliche Filter lassen sich als aktive Filter mit RC-Leitungen realisieren. Auch als Antialiasing- oder Glättungsfilter für analoge Abtastsysteme werden aktive Filter mit RC-Leitungen eingesetzt.

Aus IEEE Journal of Solid-State Circuits, Bd. SC-17, Nr. 6, Dezember 1982, S. 1076 - 1080, ist ein verteiltes RC-Element als RC-Leitung in MOS-Technologie bekannt.

Auf einem Substrat befinden sich zwei Polysilizium-Schichten, wobei die oberste Schicht den Widerstand bildet und der Kondensator durch beide Polysilizium-Schichten realisiert wird. Auch werden in Fortschritt-Berichte der VDI-Zeitschriften, Reihe 9, Analoge Zeitkontinuierliche Filter in NMOS-Technologie, 1984, S. 110 - 119, aktive Filter mit RC-Leitungen behandelt. Dort werden in NMOS-Technologie RC-Leitungen aus RC-verteilten Elementen hergestellt, indem ebenfalls drei Schichten, nämlich eine erste mäanderförmig ausgebildete Polysilizium-Schicht, dann eine Oxid-Schicht und zuletzt eine zweite flächenhaft ausgebildete Polysilizium-Schicht, auf einer Feldoxidschicht aufgebracht sind, wobei diese wiederum auf einem Halbleitersubstrat angeordnet ist. Die widerstandsbildende erste Polysilizium-Schicht bildet gleichzeitig den ersten Kapazitätsbelag der Kapazität C, dessen zweiten Kapazitätsbelag stellt die zweite Polysilizium-Schicht dar und dessen Dielektrikum wird durch die Oxid-Schicht realisiert. Dieses RC-verteilte Element kann auch in umgekehrter Weise aufgebaut werden, indem die erste Polysilizium-Schicht den zweiten Kondensatorbelag bildet und der ohmsche Widerstand in der zweiten Polysilizium-Schicht liegt und sie gleichzeitig den ersten Kondensatorbelag realisiert.

Die Vorteile einer RC-Leitung aus RC-verteilten Elementen gegenüber einem RC-Glied mit diskreten Bauelementen bestehen darin, daß ein RC-verteiltes Element weniger Chipfläche benötigt sowie dessen Dämpfungsanstieg oberhalb der 3-dB-Frequenz größer ist.

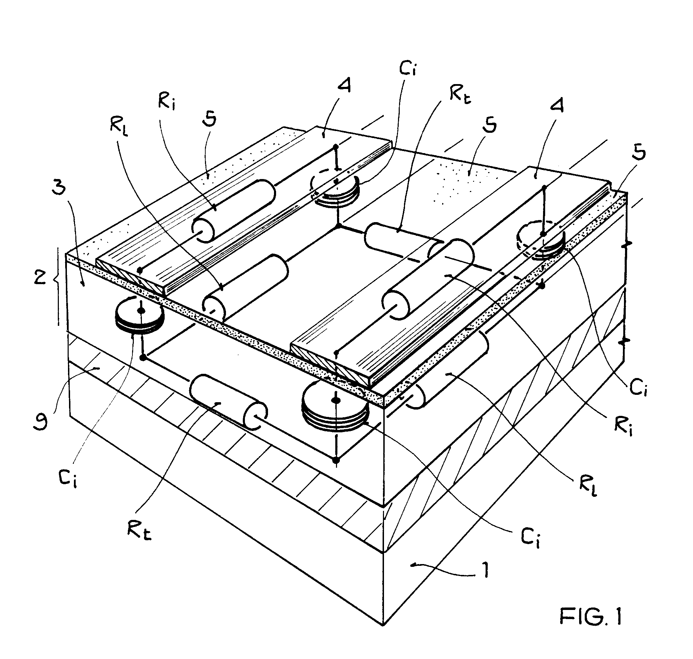

Figur 1 zeigt ein bekanntes RC-verteiltes Element mit einer Dreischichtstruktur 2, bestehend aus der ersten Polysilizium-Schicht 3, der Oxid-Schicht 5 und zweiten der Polysilizium- Schicht 4, die auf einem Halbleitergrundkörper 1 mit einer Feldoxid-Schicht 9 angeordnet ist. Die Polysilizium-Schicht 3 bildet den zweiten Kapazitätsbelag der Kapazität C, die den Widerstand R bildende Polysilizium-Schicht 4 realisiert dessen ersten Kapazitätsbelag und die Oxid-Schicht 5 dessen Dielektrikum. Das in diese Figur gezeichnete Ersatzschaltbild der RC-Leitung zeigt die sich zum Gesamtwiderstand R addierenden Widerstände $R_i$, die zur Gesamtkapazität C sich zusammensetzenden Kapazitäten $C_i$, sowie die ohmschen Parasitäten $R_t$ und $R_l$.

Diese ohmschen Parasitäten $R_t$ und $R_l$ entstehen durch die flächenhafte Ausbildung des zweiten Kapazitätsbelages und verschlechtern dadurch wesentlich die elektrischen Eigenschaften der RC-Leitung, indem zum Beispiel die Verzögerungzeit der RC-Leitung verfälscht oder die Trennschärfe in analogen Abtastsystemen verschlechtert wird.

Der Erfindung liegt die Aufgabe zugrunde, eine RC-Leitung derart anzugeben, daß die oben genannten ohmschen Parasitäten $R_t$ and $R_l$ eliminiert werden.

Diese Aufgabe wird bei einer RC-Leitung der eingangs beschriebenen Art erfindungsgemäß dadurch gelöst, daß sowohl die Polysilizium-Schichten als auch die dazwischenliegende Oxidschicht leiterbahnartig strukturiert ist, in der Weise, daß sowohl die den ersten Kapazitätsbelag bildende Widerstandsbahn als auch die den zweiten Kapazitätsbelag bzw. die das Dielektrikum bildenden Bahnen in flächensparender Weise parallel zur Ebene des Halbleitergrundkörpers gefaltet oder gerollt sind und die Schichten der Bahnen kongruent übereinander liegen.

Durch den erfindungsgemäßen Aufbau solcher RC-Leitungen werden die Frequenzeigenschaften wesentlich verbessert, da parasitäre ohmsche Kopplungen zwischen benachbarten Teilen der Leitung beseitigt werden. Ein weiterer Vorteil besteht darin, daß zur Herstellung solcher RC-Leitungen keine über die standardisierte MOS-Technologie hinausgehende Technologie notwendig ist.

Im folgenden werden die Erfindung und deren Ausgestaltung im Zusammenhang mit den Figuren näher erläutert. Es zeigt

Figur 1 eine perspektivische Darstellung einer bekannten RC-Leitung mit Ersatzschaltbild.

Figur 2a - 5b Ausführungsformen erfindungsgemäßer RC-Leitungen.

Figur 6 und 7 Ausführungsbeispiele erfindungsgemäß strukturierter Polysilizium-Bahnen.

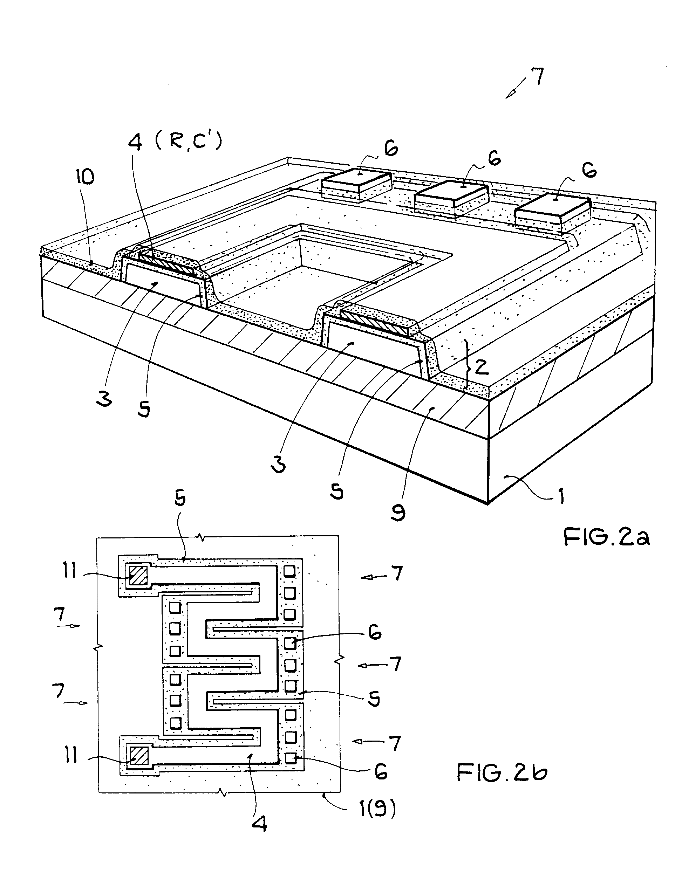

Zunächst sind im Zusammenhang mit den Figuren 2a bis 5b Ausführungsbeispiele der Erfindung beschrieben, deren Dreischichtstruktur 2 auf einer Feldoxidschicht 9, beispielsweise aus $SiO_2$, angeordnet ist und diese sich auf einem aus p-leitendem Silizium bestehenden Halbleitergrundkörper 1 befindet. Die Dreischichtstruktur 2 ist leiterbahnartig in Form eines aus Zweigen 8 und Ecken 7 bestehenden Mäanders ausgeführt, wobei die erste Bahn, Polysiliziumschicht 3, auf der Feldoxidschicht 9 angeordnet ist, darauf befindet sich die zweite Bahn, die Oxidschicht 5, und anschließend die dritte Bahn, die Polysilizium-Schicht 4, so daß die drei Bahnen kongruent übereinander liegen. Die mäanderförmige Struktur ist insbesondere aus den mit b bezeichneten Figuren mit deren Draufsichten zu erkennen, wobei erfindungsgemäß die perspektivische Darstellung der mit a bezeichneten Figuren die leiterbahnartige Ausführung der Polysilizium-Schichten 3 und 4 und der Oxidschicht 5 gegenüber der flächenhaften Ausführung gemäß dem Stand der Technik, z. B. nach Figur 1, darstellen, und dadurch die transversalen ohmschen Parasitäten $R_t$ eliminiert werden.

Die Bahn der Polysilizium-Schicht 3 bzw. 4 hat beispielsweise eine Breite von 7 $\mu m$ bzw. 6 $\mu m$ und beide Bahnen haben eine Dicke von ca. 1 $\mu m$, wobei die Oxidschicht 5 ca. 0,09 $\mu m$ dick ist. Der Abstand der ca. 500 $\mu m$ langen Zweigen des Mäanders beträgt vorteilhafterweise 6 $\mu m$. Die Dicke des Halbleitergrundkörpers 1 und der Feldoxidschicht 9 betragen beispielsweise 500 $\mu m$ bzw. 10 $\mu m$. Die Länge des Mäanders hängt von der Anzahl der Zweige 8 und der Ecken 7 ab.

Die Dreischichtstruktur 2 wird durch eine weitere Oxidschicht 10 aus $SiO_2$ mit einer Dicke von ca. 0,9 $\mu m$ abgedeckt, wobei abschließend mit Aluminium diejenige Polysilizium-Schicht 3 oder 4 durch einen Metallkontakt 6 kontaktiert wird, die gerade den zweiten Kapazitätsbelag der Kapazität C bildet.

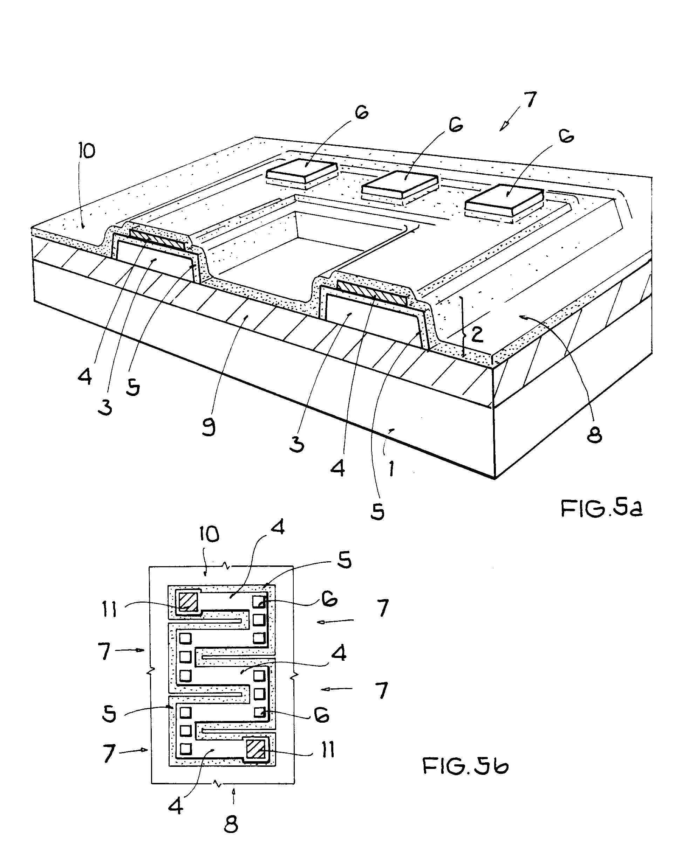

Die Ausführungsbeispiele nach den Figuren 2a - 4b unterscheiden sich von dem Ausführungsbeispiel der Figuren 5a und 5b durch die unterschiedliche Funktion der Schichten der Dreischichtstruktur 2. In den Ausführungsbeispielen der ersten Figurengruppe übernimmt die Polysilizium-Schicht 4 die Funktion des Widerstandes R als Widerstandsbahn, und gleichzeitig die des ersten Kapazitätsbelages der Kapazität C und die Polysilizium-Schicht 3 stellt dessen zweiten Kapazitätsbelag dar. In dem Ausführungsbeispiel der Figuren 5a und 5b wird dagegen von der Polysilizium-Schicht 3 der Widerstand R und der erste Kapazitätsbelag der Kapazität C und von der Polysilizium-Schicht 4 dessen zweiten Kapazitätsbelag realisiert. Die Funktion des Dielektrikums der Kapazität C wird in beiden Fällen von der Oxidschicht 5 übernommen.

Innerhalb der Figuren 2a - 4b unterscheiden sich die Ausführungsbeispiele dadurch daß die den zweiten Kapazitätsbelag bildende Bahn der Polysilizium-Schicht 3 oder 4 an unterschiedlichen Teilen des Mäanders kontaktiert ist.

Figur 2a zeigt in einer perspektivischen Teilansicht ein Ausführungsbeispiel, dessen zweite Kapazitätsbelag bildende Bahn der Polysilizium-Schicht 3 an den Ecken 7 des Mäanders durch die Oxidschichten 5 und 10 an drei Stellen mit Kontakten 6 aus Aluminium versehen sind. Die zu diesem Ausführungsbeispiel gehörende Draufsicht ist in Figur 2b mit sechs Zweigen 8 und fünf Ecken 7 dargestellt, wobei die Widerstandsbahn realisierende Polysilizium-Schicht 4 an den beiden Enden jeweils mit Kontakten 11 aus Aluminium versehen ist.

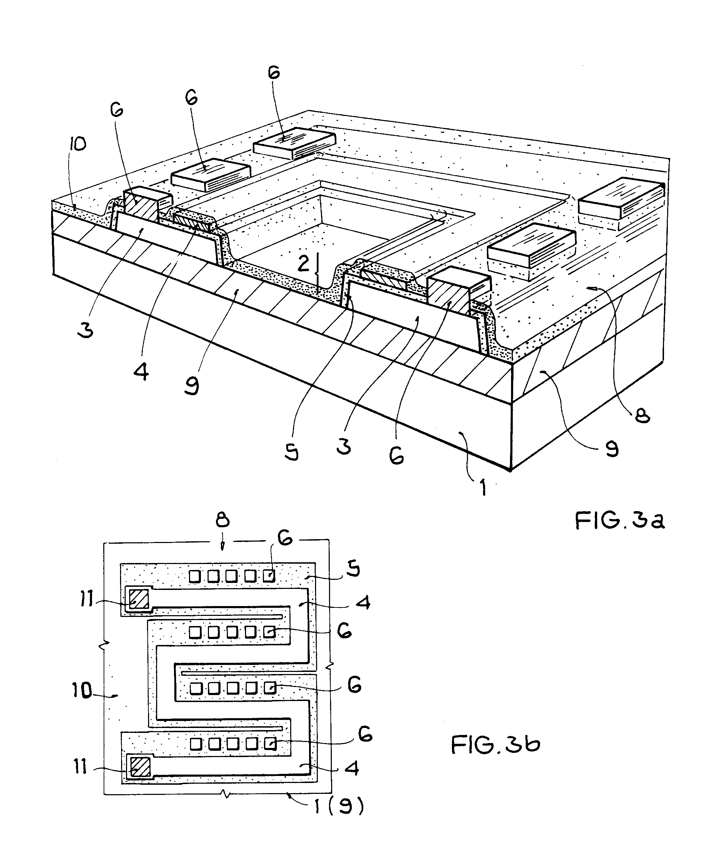

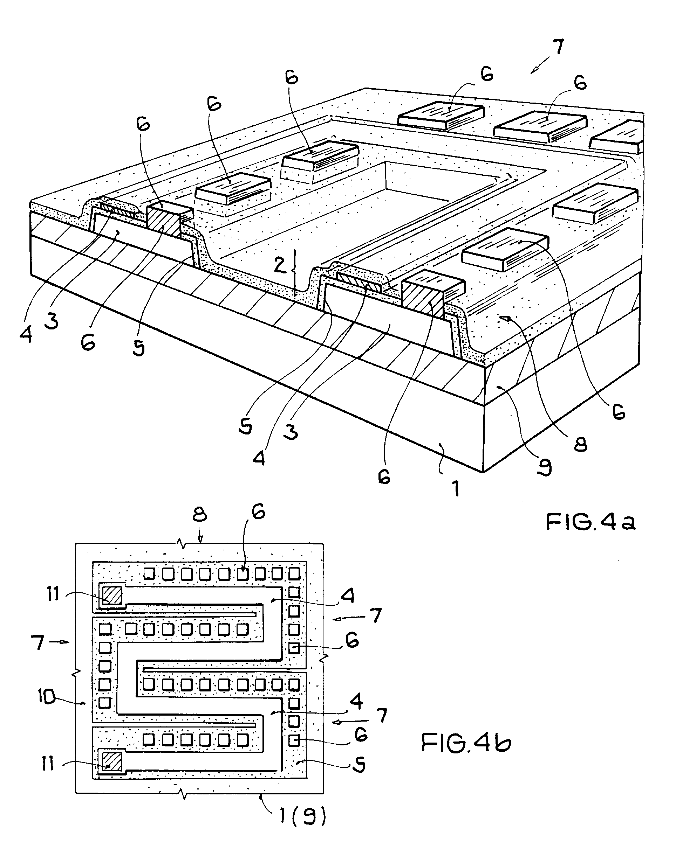

Eine vorteilhafte Ausgestaltung der Erfindung zeigen die Figuren 3a und 3b, in denen die sechs Metallkontakte 6 aus Aluminium an den Zweigen 8 des Mäanders angeordnet sind und in einer weiteren Ausgestaltung, in den Figuren 4a und 4b dargestellt, sind sowohl an den Ecken 7 als auch an den Zweigen 8 die Metallkontakte 6 angeordnet, wodurch die Polysilizium-Schicht 3 kontaktiert wird.

Bei einer weiteren in den Figuren 5a und 5b dargestellten bevorzugten Ausgestaltungsform wird die den zweiten Kapazitätsbelag bildende Bahn der Polysilizium-Schicht 4 an den Ecken 7 mit drei Metallkontakten 6 aus Aluminium versehen. Entsprechend der in den Figuren 3a - 4b dargestellten Kontaktierungsmöglichkeiten lassen sich auch bei dieser Ausgestaltungsform der Erfindung die Kontakte 6 nur an den Zweigen 8 oder sowohl an den Ecken 7 als auch an den Zweigen 8 anordnen.

Dadurch, daß die den zweiten Kapazitätsbelag bildende Bahn der Polysilizium-Schicht 3 oder 4 abschnittsweise auf gleiches Potential gelegt werden kann, werden die longitudinal auftretenden ohmschen Parasitäten $R_l$ eliminiert.

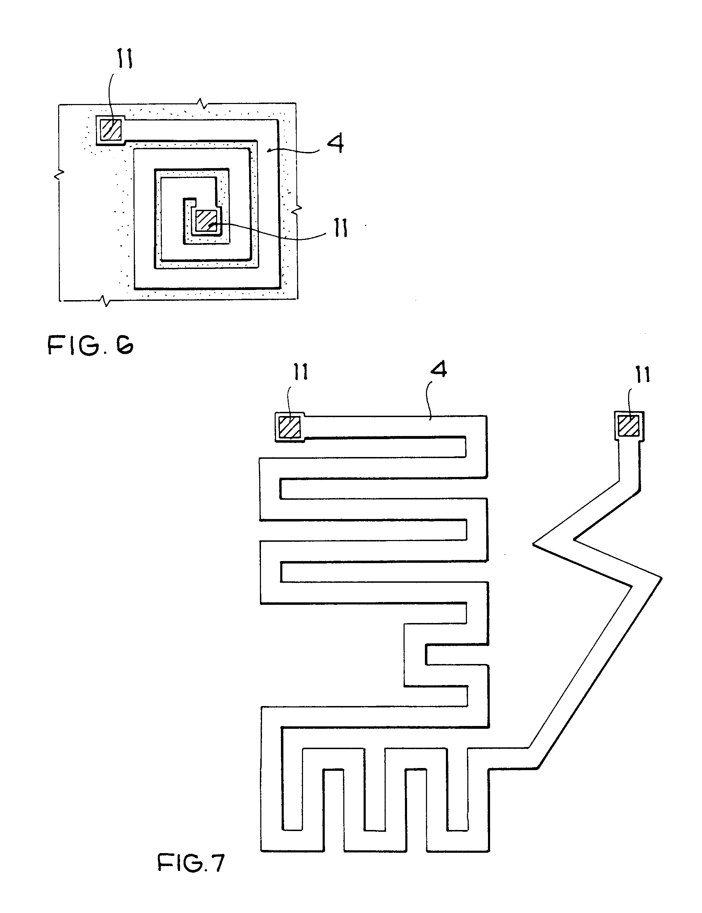

Die leiterbahnartig ausgebildete Dreischichtstruktur 2 kann auch andere Strukturen, als die in den Figuren 2a - 5b gezeigten aufweisen, beispielsweise die in Figur 6 dargestellte spiralförmige oder in Figur 7 gezeigte unregelmäßige Struktur. Zwecks Vereinfachung ist nur die Bahn der Polysilizium-Schicht 4 und die Anschlußkontakte 11 zu der Widerstandsbahn dargestellt.

## Patentansprüche

1. RC-Leitung als Dreischichtstruktur (2) auf einem Halbleitergrundkörper (1), bestehend aus zwei leitenden Polysilizium-Schichten (3, 4), wobei zwischen diesen beiden Schichten eine Oxidschicht (5) angeordnet ist, und eine der Polysilizium-Schichten (3, 4) den ohmschen Widerstand und zugleich den ersten Kapazitätsbelag bildet und die andere Polysilizium-Schicht den zweiten Kapazitätsbelag realisiert, wobei die Oxidschicht (5) das Dielektrikum darstellt, dadurch gekennzeichnet, daß sowohl die Polysilizium-Schichten (3, 4) als auch die dazwischenliegende Oxidschicht (5) leiterbahnartig strukturiert ist, in der Weise, daß sowohl die den ersten Kapazitätsbelag bildende Widerstandsbahn als auch die den zweiten Kapazitätsbelag bzw. die das Dielektrikum bildenden Bahnen in flächensparender Weise parallel zur Ebene des Halbleitergrundkörpers (1) gefaltet oder gerollt sind und die Schichten der Bahnen kongruent übereinander liegen.

2. RC-Leitung nach Anspruch 1, dadurch gekennzeichnet, daß die Dreischichtstruktur (2) auf einem passivierten Halbleitergrundkörper (1) angeordnet ist.

3. RC-Leitung nach einem der vorangehenden Ansprüche, dadurch gekennzeichnet, daß entlang der den zweiten Kapazitätsbelag bildende Bahn einer Polysilizium-Schicht (3, 4) mehrere Metallkontakte (6) angeordnet sind, die auf einem gemeinsamen Potential liegen.

4. RC-Leitung nach einem der vorangehenden Ansprüche, dadurch gekennzeichnet, daß die dielektrikumsbildende Oxidschicht aus $SiO_2$ besteht.

5. RC-Leitung nach einem der vorangehenden Ansprüche 1 - 4, dadurch gekennzeichnet, daß die erste Polysilizium-Schicht (3) den ohmschen Widerstand und den ersten Kapazitätsbelag realisiert und die zweite Polysilizium-Schicht (4) den zweiten Kapazitätsbelag bildet.

6. RC-Leitung nach einem der vorangehenden Ansprüche 1 - 4, dadurch gekennzeichnet, daß die erste Polysilizium-Schicht (3) den zweiten Kapazitätsbelag bildet und die zweite Polysilizium-Schicht (4) den ohmschen Widerstand und den ersten Kapazitätsbelag bildet.

7. RC-Leitung nach einem der vorangehenden Ansprüche, dadurch gekennzeichnet, daß sowohl die beiden leiterbahnartig strukturierten Polysilizium-Schichten (3, 4) als auch die leiterbahnartig strukturierte, dielektrikumsbildende Oxidschicht (5) mäanderförmig ausgebildet sind und kongruent übereinander liegen, und daß an den Ecken (7) der mäanderförmigen, den zweiten Kapazitätsbelag bildende Bahn einer Polysilizium-Schicht (3, 4) Metallkontakte (6) angeordnet sind, die auf einem gemeinsamen Potential liegen.

8. RC-Leitung nach einem der vorangehenden Ansprüche 1 - 6, dadurch gekennzeichnet, daß sowohl die beiden leiterbahnartig strukturierten Polysilizium-Schichten (3, 4) als auch die leiterbahnartig strukturierte, dielektrikumsbildende Oxidschicht (5) mäanderförmig ausgebildet sind und kongruent übereinander liegen, und daß an den Zweigen (8) der mäanderförmigen, den zweiten Kapazitätsbelag bildende Bahn einer Polysilizium-Schicht (3, 4) Metallkontakte (6) angeordnet sind, die auf einem gemeinsamen Potential liegen.

9. RC-Leitung nach einem der vorangehenden Ansprüche 1 - 6, dadurch gekennzeichnet, daß sowohl die beiden leiterbahnartig strukturierten Polysilizium-Schichten (3, 4) als auch die leiterbahnartig strukturierte, dielektrikumsbildende Oxidschicht (5) mäanderförmig ausgebildet sind und kongruent übereinander liegen, und daß sowohl an den Ecken (7) als auch an den Zweigen (8) der mäanderförmigen, den zweiten Kapazitätsbelag bildende Bahn einer Polysilizium-Schicht (3, 4) Metallkontakte (6) angeordnet sind, die auf einem gemeinsamen Potential liegen.

**Claims**

1. RC line as a three layer structure (2) on a semiconductor body (1), comprising two conductive polysilicon layers (3, 4) wherein an oxide layer (5) is arranged between these two layers and one of the polysilicon layers (3, 4) forms the ohmic resistance and at the same time the first plate of the capacitor and the other polysilicon layer realises the second plate of the capacitor while the oxide layer (5) constitutes the dielectric, characterised in that, the polysilicon layers (3, 4) as well as the intermediate oxide layer (5) is structured in the form of a conductive track in the manner that the resistance track forming the first plate of the capacitor as well as the tracks respectively forming the second plate of the capacitor and the dielectric are folded or rolled in a space saving manner parallel to the plane of the semi conductor body (1) and the layers of the tracks lie congruently one above the other.

2. RC line in accordance with Claim 1, characterised in that, the three layer structure (2) is arranged on a passivated semiconductor body (1).

3. RC line in accordance with any of the preceding Claims, characterised in that, several metal contacts (6), which are at a common potential, are arranged along the track of a polysilicon layer (3, 4) forming the second plate of the capacitor.

4. RC line in accordance with any of the preceding Claims, characterised in that, the oxide layer forming the dielectric consists of $SiO_2$.

5. RC line in accordance with any of the preceding Claims 1 - 4, characterised in that, the first polysilicon layer (3) realises the ohmic resistance and the first plate of the capacitor and the second polysilicon layer (4) forms the second plate of the capacitor.

6. RC line in accordance with any of the preceding Claims 1 - 4, characterised in that, the first polysilicon layer (3) forms the second plate of the capacitor and the second polysilicon layer (4) realises the ohmic resistance and the first plate of the capacitor.

7. RC line in accordance with any of the preceding Claims, characterised in that, the two polysilicon layers (3, 4) structured in the form of a conductive track as well as the oxide layer (5) forming a dielectric and structured in the form of a conductive track are constructed in the shape of a serpentine and lie congruently one above the other, and that metal contacts (6), which are at a common potential, are arranged at the corners (7) of the serpentine shaped track of a polysilicon layer (3, 4) forming the second plate of the capacitor.

8. RC line in accordance with any of the preceding Claims 1 - 6, characterised in that, the two polysilicon layers (3, 4) structured in the form of a conductive track as well as the oxide layer (5) forming a dielectric and structured in the form of a conductive track are constructed in the shape of a serpentine and lie congruently one above the other, and that metal contacts (6), which are at a common potential, are arranged on the branches (8) of the serpentine shaped track of a polysilicon layer (3, 4) forming the second plate of the capacitor.

9. RC line in accordance with any of the preceding Claims 1 - 6, characterised in that, the two polysilicon layers (3, 4) structured in the form of a conductive track as well as the oxide layer (5) forming a dielectric and structured in the form of a conductive track are constructed in the shape of a serpentine and lie congruently one above the other, and that metal contacts (6), which are at a common potential, are arranged both at the corners (7) and on the branches (8) of the serpentine shaped track of a polysilicon layer (3, 4) forming the second plate of the capacitor.

**Revendications**

1. Circuit RC sous la forme d'une structure à trois couches (2) sur un corps semi-conducteur de base (1), constitué de deux couches de polysilicium (3, 4) conductrices et d'une couche d'oxyde (5) disposée entre ces deux couches, l'une des couches de polysilicium (3, 4) formant a la fois la résistance ohmique et la première armature de la capacité et l'autre couche de polysilicium formant la seconde armature de la capacité, la couche d'oxyde (5) représentant le diélectrique, caractérisé en ce que les couches de polysilicium (3, 4) comme la couche d'oxyde (5) interposée entre elles sont structurées à la façon de pistes conductives, de manière qu'aussi bien la piste résistive formant la première armature de la capacité que les pistes formant respectivement la seconde armature de la capacité et le diélectrique, soient pliées ou enroulées parallèlement au plan du corps semi-conducteur de base (1), de façon à faire gagner de l'aire de surface, et avec superposition des couches des pistes de manière qu'elles se recouvrent mutuellement.

2. Circuit RC selon la revendication 1, caractérisé en ce que la structure à trois couches (2) est disposée sur un corps semi-conducteur de base (1) passivé.

3. Circuit RC selon une des revendications précédentes, caractérisé en ce que plusieurs contacts métalliques (6) sont disposés le long de la piste d'une couche de polysilicium (3, 4) formant la seconde armature de la capacité, contacts métalliques (6) qui présentent un potentiel commun.

4. Circuit RC selon une des revendications précédentes, caractérisé en ce que la couche d'oxyde formant le diélectrique est en $SiO_2$.

5. Circuit RC selon une des revendications 1-4 précédentes, caractérisé en ce que la première couche de polysilicium (3) forme la résistance ohmique et la première armature de la capacité et la seconde couche de polysilicium (4) forme la seconde armature de la capacité.

6. Circuit RC selon une des revendications 1-4 précédentes, caractérisé en ce que la première couche de polysilicium (3) forme la seconde armature de la capacité et la seconde couche de polysilicium (4) forme la résistance ohmique et la première armature de la capacité.

7. Circuit RC selon une des revendications précédentes, caractérisé en ce que les deux couches de polysilicium (3, 4), structurées à la façon de pistes conductives, comme la couche d'oxyde (5) formant le diélectrique et qui est également structurée à la façon d'une piste conductive, sont conformées en grecques (méandres) et se superposent en se recouvrant mutuellement, et que des contacts métalliques (6) sont disposés aux angles (7) de la piste en grecques d'une couche de polysilicium (3, 4) formant la seconde armature de la capacité, contacts métalliques (6) qui présentent un potentiel commun.

8. Circuit RC selon une des revendications 1-6 précédentes, caractérisé en ce que les deux couches de polysilicium (3, 4), structurées à la façon de pistes conductives, comme la couche d'oxyde (5) formant le diélectrique et qui est également structurée à la façon d'une piste conductive, sont conformées en grecques (méandres) et se superposent en se recouvrant mutuellement, et que des contacts métalliques (6) sont disposés sur les branches (8) de la piste en grecques d'une couche de polysilicium (3, 4) formant la seconde armature de la capacité, contacts métalliques (6) qui présentent un potentiel commun.

9. Circuit RC selon une des revendications 1-6 précédentes, caractérisé en ce que les deux couches de polysilicium (3, 4), structurées à la façon de pistes conductives, comme la couche d'oxyde (5) formant le diélectrique et qui est également structurée à la façon d'une piste conductive, sont conformées en grecques (méandres) et se superposent en se recouvrant mutuellement, et que des contacts métalliques (6) sont disposés à la fois aux angles (7) et sur les branches (8) de la piste en grecques d'une couche de polysilicium (3, 4) formant la seconde armature de la capacité, contacts métalliques 16) qui présentent un potentiel commun.

FIG. 1

FIG.2a

FIG.2b

FIG.3a

FIG.3b

FIG.4a

FIG.4b

FIG.5a

FIG.5b

FIG. 6

FIG.7